(19) Europäisches Patentamt
European Patent Office
Office européen des brevets

(11) **EP 3 016 146 A1**

(12) **EUROPEAN PATENT APPLICATION**
published in accordance with Art. 153(4) EPC

(43) Date of publication:
**04.05.2016 Bulletin 2016/18**

(21) Application number: **13887821.0**

(22) Date of filing: **26.06.2013**

(51) Int Cl.:
**H01L 29/861** $^{(2006.01)}$     **H01L 29/868** $^{(2006.01)}$

(86) International application number:
**PCT/JP2013/067564**

(87) International publication number:
**WO 2014/207853 (31.12.2014 Gazette 2014/53)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicants:
• **The University of Electro-Communications**
**Chofu-shi**
**Tokyo 182-8585 (JP)**
• **Nihon Dengyo Kosaku Co., Ltd.**
**Tokyo 102-0074 (JP)**

(72) Inventors:
• **NOZAKI, Shinji**
**Chofu-shi**
**Tokyo 182-8585 (JP)**

• **UCHIDA, Kazuo**
**Chofu-shi**
**Tokyo 182-8585 (JP)**
• **KUROKAWA, Shingo**
**Tokyo 102-0074 (JP)**
• **FURUKAWA, Minoru**
**Tokyo 102-0074 (JP)**
• **SHIRATO, Tadashi**
**Tokyo 102-0074 (JP)**

(74) Representative: **Schwabe - Sandmair - Marx**
**Patentanwälte Rechtsanwalt**
**Partnerschaft mbB**
**Stuntzstraße 16**
**81677 München (DE)**

(54) **RECTIFYING ELEMENT**

(57) A rectifying element includes a first electrode having a first work function, a second electrode having a second work function larger than the first work function, and a semiconductor layer having a third work function that is a value between the first work function and the second work function, and joined to the first electrode and the second electrode. Favorably, the semiconductor layer is set to have a thickness with which the semiconductor layer becomes fully depleted in a state where a bias voltage is not applied between the first electrode and the second electrode. Accordingly, the rectifying element that realizes a high-speed switching characteristic and sufficient rectification properties can be provided.

FIG.1

## Description

Field

The present invention relates to a rectifying element.

Background

A rectenna (rectifying antenna) element is an element that receives a high frequency such as a microwave and converts the high frequency into DC power. The rectenna element is expected to be applied to a power regeneration technology and a wireless power supply technology. As the wireless power supply technology, an application to a space solar power satellite (SPS) concept is expected, in which the power is sent from a huge solar power station provided in the outer space to the ground using a radio wave in a microwave range (3 to 30 GHz).
A rectifying element is used for the rectenna element. Patent Literature 1 discloses a rectenna element using a PN junction diode as the rectifying element.

Citation List

Patent Literature

Patent Literature 1: Japanese Translation of PCT Application No. 2008-516455

Non Patent Literature

Non Patent Literature 1: B. Berland, "Photovoltaic Technologies Beyond the Horizon: Optical Rectenna Solar Cell Final Report 1 August 2001-30 September 2002", National Renewable Energy Laboratory, February 2003.
Non Patent Literature 2: I. Hotovy et al, "Characterization of NiO thin films deposited by reactive sputtering", Vacuum, volume 50, number 1-2 pp. 41-44 (1998).
Non Patent Literature 3: R. Srnanek et al., "A Raman study of NiOx films for gas sensors applications", ASDAM 2000. The Third International Euro Conference on Advanced Semiconductor Devices and Microsystems, pp. 303-306.

Summary

Technical Problem

By the way, in recent years, as a method of realizing a next-generation highly efficient solar cell, an optical rectenna that receives light and converts the light into a DC current has drawn attention (Non Patent Literature 1). Since the light has a higher frequency (for example, 150 THz or more) than the microwave, a rectifying element having a higher-speed switching characteristic is required. Therefore, in Non Patent Literature 1, a metal-insulator-metal (MIM) type tunnel diode, which is expected to have a high-speed switching characteristic, is used.
However, the conventional MIM type tunnel diode has not obtained a sufficient asymmetric I-V characteristic and sufficient rectification properties.
Meanwhile, a Schottky diode realizes the rectification properties by a Schottky barrier. The Schottky diode is a majority carrier device, which is different from the PN junction diode, and thus has a fast switching speed and can perform switching at a high frequency. However, in a normal Schottky diode, a majority carrier outside a depletion layer needs to move toward the Schottky junction in order to perform switching from a reverse direction to a forward direction. Since this movement takes a time, even a Schottky diode for high frequency made of GaAs is said to have a frequency response of 5 THz.
The present invention has been made in view of foregoing, and an objective is to provide a rectifying element that realizes a high-speed switching characteristic and sufficient rectification properties.

Solution to Problem

In order to solve the above problems and to attain the objective, a rectifying element according to the present invention includes: a first electrode having a first work function; a second electrode having a second work function larger than the first work function; and a semiconductor layer having a third work function that is a value between the first work function and the second work function, and joined to the first electrode and the second electrode.

In the rectifying element according to the present invention, the semiconductor layer is set to have a thickness with which the rectifying element becomes fully depleted in a state where a bias voltage is not applied between the first electrode and the second electrode, in the above invention.

In the rectifying element according to the present invention, a carrier of the semiconductor layer is a hole, in the above invention.

In the rectifying element according to the present invention, the semiconductor layer is made of a metal oxide, in the above invention.

In the rectifying element according to the present invention, the metal oxide is an NiOx (x = 1 to 1.5), in the above invention.

In the rectifying element according to the present invention, the metal oxide is an NiOx (x = 1 to 1.5), the first electrode is made of Al, and the second electrode is made of Ni, in the above invention.

In the rectifying element according to the present invention, a hole concentration in the NiOx is in a $10^{-2}$ cm$^{-3}$ range to a $10^{17}$ cm$^{-3}$ range, in the above invention.

In the rectifying element according to the present invention, the metal oxide is an NiOx (x = 1 to 1.5), the first electrode is made of Ni, the second electrode is made of Pt, in the above invention.

In the rectifying element according to the present invention, a hole concentration in the NiOx is in a $10^{17}$ cm$^{-3}$ range or more, in the above invention.

In the rectifying element according to the present invention, the metal oxide is generated in a manner that a metal serving as a raw material of the metal oxide is irradiated with an ultraviolet ray and oxidized, in the above invention.

Advantageous Effects of Invention

According to the present invention, an effect to realize a rectifying element having a high-speed switching characteristic and sufficient rectification properties is exhibited.

Brief Description of Drawings

FIG. 1 is a schematic cross-sectional view of a rectifying element according to an embodiment.
FIG. 2A is a diagram illustrating an energy band structure.
FIG. 2B is a diagram illustrating an energy band structure.
FIG. 3 is a diagram illustrating a relationship between electronegativity of principal metals and work functions.
FIG. 4 is a diagram illustrating the Raman spectra of produced NiOx thin films.
FIG. 5 is a diagram illustrating the I-V characteristic of a produced NiOx thin film.

Description of Embodiments

Hereinafter, embodiments of a rectifying element according to the present invention will be described in detail with reference to the drawings. Note that the invention is not limited by the embodiments.

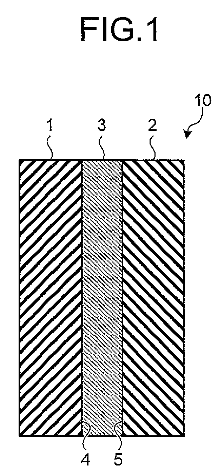

FIG. 1 is a schematic cross-sectional view of a rectifying element according to an embodiment. As illustrated in FIG. 1, a rectifying element 10 includes a first electrode 1, a second electrode 2, and a semiconductor layer 3 joined to the first electrode 1 and the second electrode 2. The first electrode 1 and the semiconductor layer 3 are joined at an interface 4, and the second electrode 2 and the semiconductor layer 3 are joined at an interface 5.

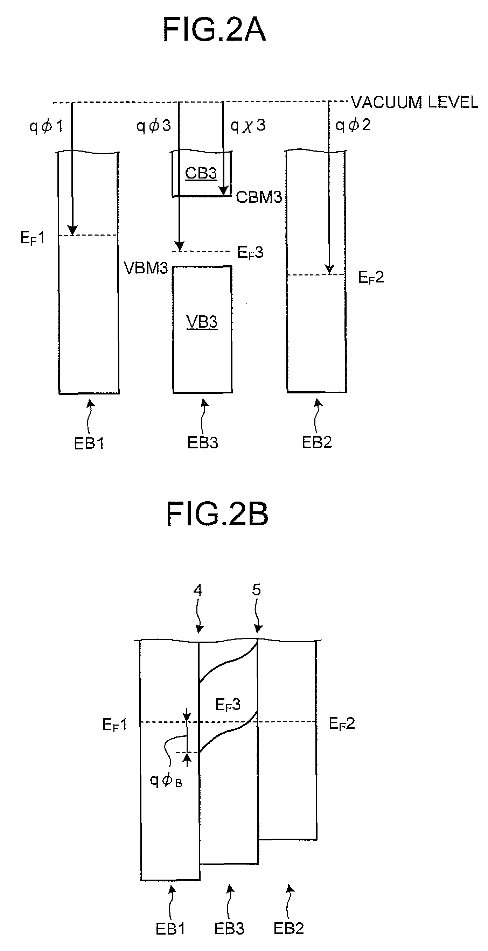

FIGS. 2A and 2B are diagrams illustrating energy band structures. FIG. 2A illustrates energy band structures EB1, EB2, and EB3 of the first electrode 1, the second electrode 2, and the semiconductor layer 3 before joining, and FIG. 2B illustrates the energy band structures EB1, EB2, and EB3 after joining (in a thermal equilibrium state and in a state of configuring the rectifying element 10).

As illustrated in the energy band structure EB1 of FIG. 2A, the first electrode 1 has a work function $q\varphi1$ based on the vacuum level. Note that $E_F1$ represents a Fermi level.

As illustrated in the energy band structure EB2 of FIG. 2A, the second electrode 2 has a work function $q\varphi2$ that is larger than the work function $q\varphi1$ of the first electrode 1. $E_F2$ represents a Fermi level.

As illustrated in the energy band structure EB3 of FIG. 2A, the semiconductor layer 3 is a P type semiconductor, and has a work function $q\varphi3$ of a value between the work function $q\varphi1$ and the work function $q\varphi2$. $E_F3$ represents a Fermi level, CB3 represents a conduction band, CBM3 represents a lower end of the conduction band, VB3 represents a valence band, VBM3 represents an upper end of the valence band, and $q\chi3$ represents electron affinity.

Next, as illustrated in FIG. 2B, when the first electrode 1, the second electrode 2, and the semiconductor layer 3 are joined, and become in a thermal equilibrium, the Fermi levels $E_F1$, $E_F2$, and $E_F3$ coincide with one another. At this time, the energy band of the semiconductor layer 3 in the vicinity of the interfaces 4 and 5 is bent according to magnitude relation among the work functions $q\varphi1$, $q\varphi2$, and $q\varphi3$, and the first electrode 1 and the semiconductor layer 3 form a Schottky junction on the interface 4 between the first electrode 1 and the semiconductor layer 3, and the second electrode 2 and the semiconductor layer 3 form an ohmic junction on the interface 5 between the second electrode 2 and the semiconductor layer 3. Accordingly, a Schottky barrier $q\varphi_B$ is formed on the interface 4.

As a result, the rectifying element 10 functions as a Schottky diode, and sufficient rectification properties can be obtained. Further, the rectifying element 10 has a higher-speed switching characteristic than the PN junction diode. Further, if the thickness of the semiconductor layer 3 is set to a thickness with which the semiconductor layer 3 becomes completely depleted in a state where no bias voltage is applied between the first electrode 1 and the second electrode 2 (a 0 bias state), occurrence of a parasitic capacity due to movement of the majority carrier outside the depletion layer toward the Schottky junction can be prevented. As a result, a further higher-speed switching characteristic can be obtained.

Hereinafter, the present embodiment will be described in more detail with a specific example of the first electrode 1, the second electrode 2, and the semiconductor layer 3.

As the semiconductor layer 3, for example, it is favorable to use a thin film made of a metal oxide. That is, to realize a semiconductor layer having a thickness with which it becomes completely depleted at the 0 bias, the semiconductor layer is favorably a thin film. However, when trying to produce a semiconductor thin film of an ultrathin film on a metal electrode with a crystal semiconductor material, such a semiconductor having an ultrathin film is difficult to have crystal growth. Further, even if trying to produce the ultrathin film by deposition, the quality of the ultrathin film is easily deteriorated, such as an increase in a defect like a pinhole. Therefore, the metal electrodes may be short circuited.

In contrast, when a thin film made of a metal oxide is used as the semiconductor layer, the semiconductor layer can be formed by oxidation of a metal surface, and thus the production is easy. As the metal oxide, a zinc oxide, an indium oxide, a tin oxide, a nickel oxide, or the like can be used. Especially, when the nickel oxide is used, a semiconductor layer having an ultrathin film, which has good quality and has less defects such as pinholes, can be favorably realized. Note that, when the semiconductor layer is an N type semiconductor, the first electrode forms an ohmic junction with the semiconductor layer, and thus becomes an ohmic electrode, and the second electrode forms a Schottky junction with the semiconductor layer, and thus becomes a Schottky electrode. The zinc oxide, the indium oxide, and the tin oxide may become an N type semiconductor.

A case of using a nickel oxide as the semiconductor layer will be described. Hereinafter, the nickel oxide is appropriately expressed as NiOx (x = 1 to 1.5). It is known that an oxygen-excessive NiOx exhibits a P type conductive type. However, it has been difficult to control a hole concentration of the NiOx to control the P type conductivity.

However, as a result of diligent study, the inventors of the present invention have found out to be able to control the oxygen content of the NiOx (that is, the value of x) to adjust the hole concentration, thereby to realize an NiOx having the work function $q\varphi3$ of a value between the work function $q\varphi1$ of the first electrode 1 and the work function $q\varphi2$ of the second electrode 2.

Further, the inventors of the present invention have found out that it is favorable to irradiate an ultraviolet ray to generate a nickel oxide as a method of producing the NiOx. That is, when the NiOx is produced by thermal oxidation, nickel is not oxidized by the thermal oxidation at a low temperature of 500°C or less. Also, in the thermal oxidation at a higher temperature than 500°C, a NiOx having high resistance is produced. Therefore, when the thermal oxidation is used, it is difficult to control the hole concentration of the NiOx. Meanwhile, according to the findings of the inventors of the present invention, when oxidation is performed at a treatment temperature of 300°C or less while the ultraviolet irradiation is performed, a generated NiOx exhibits P type conduction. Further, the inventors have found out that it is possible to control the conductivity of the NiOx (or the hole concentration or the work function) according to conditions such as the treatment temperature, an oxidizing species (oxygen, or water vapor), pressure of the oxidizing species, and the like.

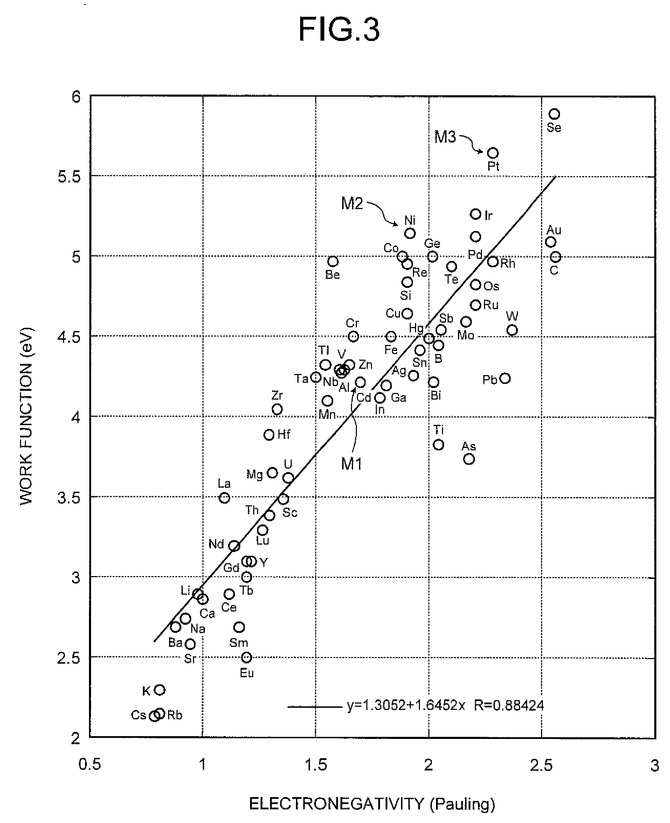

Next, favorable materials of the first electrode and the second electrode will be described. FIG. 3 is a diagram illustrating a relationship between electronegativity (Pauling) of principal metals and the work functions. Selection of the work functions of normal metals that can form a film by vacuum deposition is limited, and the work functions of Al, In, and Ga are about 4.1 eV, which is low.

Meanwhile, as described above, a high-quality NiOx is obtained by oxidation of Ni, and contact between Ni and NiOx is good. Further, the work function of Ni is 5.1 eV. Therefore, for example, the material of the first electrode 1 is Al illustrated by the reference sign M1 in FIG. 3, the material of the second electrode 2 is Ni illustrated in the reference sign M2 in FIG. 3, and the semiconductor layer 3 is the NiOx thin film, the work function of which is controlled to become a value between the work function (4.1 eV) of Al and the work function (5.1 eV) of Ni, whereby the rectifying element according to the present embodiment can be realized.

To control the work function of the NiOx to become the value between 4.1 eV and 5.1 eV, an energy difference

($E_F$ - $E_V$) between the Fermi level and the lower end of the valence band of the NiOx may just be 0.2 to 1.3 eV, considering that the electron affinity $q\chi 3$ of the NiOx is 1.7 to 1.8 eV. To realize this work function, the hole concentration of the NiOx thin film favorably falls in the $10^{-2}$ cm$^{-3}$ range to the $10^{17}$ cm$^{-3}$ range.

Hereinafter, the hole concentration will be more specifically described. A hole concentration p of the NiOx is expressed by the following formula (1):

$$p = N_V \exp\left( -\frac{E_F - E_V}{kT} \right) \qquad (1)$$

$N_V$ is effective density of states of a valence band, k is the Boltzmann constant, and T is an absolute temperature. Further, $N_V$ is expressed by the following formula (2):

$$N_V = 2\left( 2\pi m^* \frac{kT}{h^2} \right)^{\frac{3}{2}}, \qquad m^* = 6m_0 \qquad (2)$$

$m^*$ is an effective mass of a hole, $m_0$ is a rest mass of an electron, and h is the Planck's constant.

As an example, when $N_V \sim 3.7 \times 10^{20}$ cm$^{-3}$ in the vicinity of the room temperature (T $\sim$ 300 K), a favorable hole concentration is $7 \times 10^{-2}$ to $1.7 \times 10^{17}$ cm$^{-3}$, which is in the $10^{-2}$ cm$^{-3}$ range to the $10^{17}$ cm$^{-3}$ range.

In the above description, the material of the first electrode 1 is Al, the material of the second electrode 2 is Ni, and the semiconductor layer 3 is the NiOx thin film. However, the present embodiment is not limited to the above example. For example, the material of the first electrode 1 is Ni, the material of the second electrode 2 is Pt illustrated by the reference sign M3 of FIG. 3, and the semiconductor layer 3 is the NiOx thin film, the work function of which is a value between the work function (5.1 eV) of Ni and the work function (5.7 eV) of Pt, whereby the rectifying element according to the present embodiment can be realized.

To control the work function of the NiOx to become the value between 5.1 eV and 5.7 eV, the hole concentration in the NiOx may just be the $10^{17}$ cm$^{-3}$ range (for example, $1.7 \times 10^{17}$ cm$^{-3}$) or more. An upper limit of the hole concentration can be set up to about a high concentration with which the semiconductor degenerates.

Next, a favorable thickness of the semiconductor layer 3 will be described. As described above, if the thickness of the semiconductor layer 3 is set to a thickness that causes complete depletion in the 0 bias state, a higher-speed switching characteristic can be obtained, and thus it is favorable. The complete depletion can be more easily realized as the thickness of the semiconductor layer 3 is thinner. Meanwhile, to decrease the capacity of the rectifying element 10, a thicker thickness of the semiconductor layer 3 is favorable. Therefore, the thickness of the semiconductor layer 3 is most favorably a maximum thickness that causes the complete depletion.

A depletion width $W_D$ of the Schottky diode in the 0 bias state is expressed by the following formula (3):

$$W_D = \sqrt{\frac{2\varepsilon_S}{qN_A}\left( \varphi_B - \frac{kT}{q} \right)} \qquad (3)$$

$\varepsilon_S$ is a dielectric constant of the semiconductor layer 3, q is an elementary charge, $N_A$ is the hole concentration (corresponding to p of the formula (1)).

A case in which the material of the first electrode 1 is Al, the material of the second electrode 2 is Ni, and the semiconductor layer 3 is the NiOx thin film will be described as an example. Consider a case in which the work function of the NiOx is set to 4.6 eV that is a mean value between the work function (4.1 eV) of Al and the work function (5.1 eV) of Ni. In this case, from the formula (1), the hole concentration is $1.6 \times 10^7$ cm$^{-3}$. When the electron affinity $q\chi 3$ of the NiOx is 1.8 eV, and a relative dielectric constant of the NiOx is 12, $W_D$ becomes 6,400 $\mu$m (0.64 cm) from the formula (3). Therefore, if the thickness of the NiOx thin film is made 0.64 cm or less, the completed depletion is realized in the 0 bias state, and thus it is favorable. Note that, when the thickness is about 0.64 cm, it is not too thin. Therefore, a good-quality NiOx thin film without pinholes can be easily produced, and thus it is favorable. When the thickness of the NiOx thin film is 0.64 cm, the capacity per unit area is $1.7 \times 10^{-12}$ F/cm$^2$. In this case, even if the size of the surface area of the rectifying element 10 is a 1 $\mu$m square, the capacity of the element is $1.7 \times 10^{-20}$ F, and is sufficiently small to realize a high-speed switching characteristic. Note that, when the electron affinity q$\chi$3 of the NiOx is 1.7 eV, $W_D$ is 0.094 cm. In this case, the good-quality NiOx thin film can be also easily produced.

Note that the maximum thickness that realizes the complete depletion becomes thicker as the hole concentration of the NiO thin film is lower. Therefore, it is favorable in terms of easiness of realization of the complete depletion, easiness of formation of the semiconductor layer, and good quality.

Next, a method of producing a favorable NiOx thin film will be further described. As described above, according to the findings of the inventors of the present invention, when the oxidation is performed at the treatment temperature of 300°C or less while the ultraviolet radiation is performed, the generated NiOx exhibits P type conduction. Further, the electrical conductivity (or the hole concentration or the work function) of the NiOx can be controlled according to the conditions such as the treatment temperature, the oxidizing species (oxygen or water vapor), the pressure of the oxidizing species, and the like. Accordingly, the semiconductor layer 3 made of the NiOx having an appropriately controlled work function can be favorably realized.

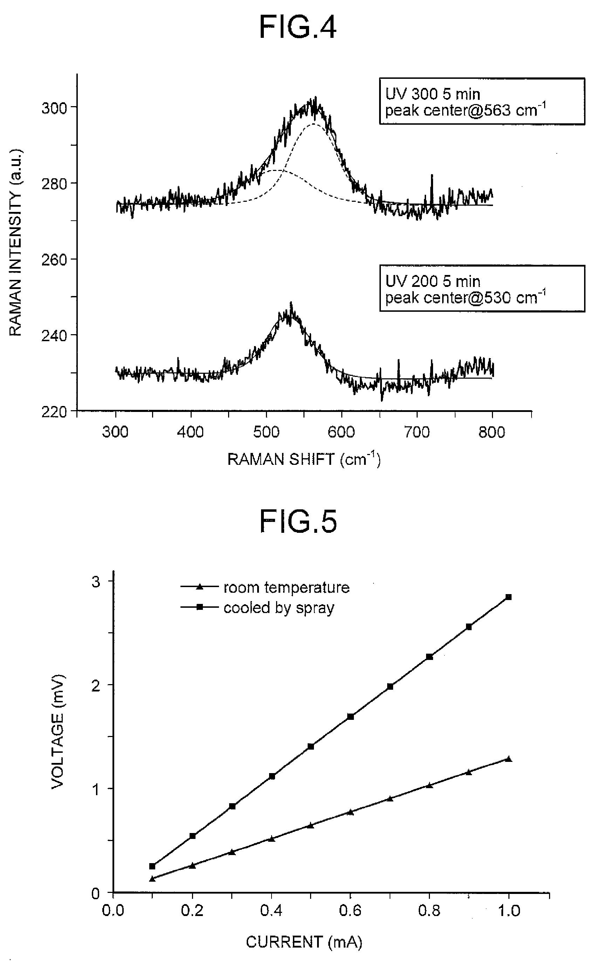

FIG. 4 is a diagram illustrating the Raman spectra of NiOx thin films produced by the inventors of the present invention. In FIG. 4, oxidation was performed by irradiating a surface of a nickel deposited film with an ultraviolet ray under an $O_2$ atmosphere. As an ultraviolet light source, a metal halide lamp having maximum spectrum intensity distribution in the vicinity of a wavelength of 380 nm was used. The thermal treatment temperature was 200°C or 300°C, and the treatment time was five minutes. It can be considered that, in the Raman spectra illustrated in FIG. 4, the oxygen content in the NiOx film is larger and the hole concentration is higher as the Raman shift of the peak is larger (the wavenumber is higher) (see Non Patent Literatures 2 and 3). Therefore, it can be considered that the hole concentration is higher in the case where the thermal treatment temperature is 300°C (the peak center is 563 cm$^{-1}$) than the case of 200°C (the peak center is 530 cm$^{-1}$). FIG. 4 indicates that the oxygen content and the hole concentration in the NiOx thin film can be adjusted by adjusting the treatment temperature.

FIG. 5 illustrates the I-V characteristic of the produced NiOx thin film. In FIG. 5, the I-V characteristic of the NiOx film produced at the treatment temperature of 300°C illustrated in FIG. 4 was measured by a four prove method. Note that the measurement was performed in states of room temperature and of where the NiOx thin film was cooled by cool spray. From FIG. 5, it has been confirmed that the resistance (inclinations of the I-V characteristic) of the produced NiOx thin film is increased in a large manner, and thereby a semiconductor characteristic is exhibited. That is, it has been confirmed that an NiOx thin film of a semiconductor, the hole concentration or the work function of which can be controlled by the above-described method, can be produced.

Therefore, the rectifying element 10 can be produced such that an NiOx thin film, the work function or the hole concentration of which has been appropriately controlled by the above method, is formed on a surface of an Ni electrode obtained by vacuum deposition, and an Al electrode or a Pt electrode obtained by vacuum deposition is joined to sandwich the NiOx thin film.

Further, for example, the rectifying element 10 can be produced as follows. First, a Pt/Ti electrode (each thickness is 20 nm) and an Ni thin film (the thickness is 100 nm) are formed in order on an Si substrate with an $SiO_2$ film formed on a surface, by electron beam lithography, electron beam deposition, and lift-off. Next, the Ni thin film is oxidized to have a predetermined thickness, and an NiOx thin film that forms an ohmic junction with the Ni thin film is formed. Further, an Al/Pt electrode (respective thicknesses are 100 nm and 20 nm) are formed on the NiOx thin film by electron beam lithography, electron beam deposition, and lift-off. Accordingly, the rectifying element 10 can be produced. Here, Ti in the Pt/Ti electrode is formed between Pt and the $SiO_2$ film to enhance adhesion. Pt in the Al/Pt electrode is used for an extraction electrode using a characteristic that Pt is less likely to be oxidized. Further, if the Pt/Ti electrode and the Al/Pt electrode are formed into comb shapes having a comb-teeth width of about 300 nm and a comb-teeth length of about 100 $\mu$m, and intersecting with each other, the rectifying element 10 is formed in a portion where these comb-shaped electrodes intersect with each other. Further, the Al/Pt electrode of a surface side is extended and is formed into a shape of an optical antenna, whereby the optical rectenna having the configuration exemplarily disclosed in Non Patent Literature 1, and the like, can be formed.

Note that, in the above-described embodiment, the semiconductor layer is a P type semiconductor. However, the semiconductor layer may be an N type semiconductor. In this case, the semiconductor layer forms an ohmic junction with the first electrode, and forms a Schottky junction with the second electrode.

Further, the present invention is not limited by the above-described embodiments. A configuration of an appropriate combination of the above-described configuration elements is also included in the present invention. Further, more effects and modifications can be easily led by a person skilled in the art. Therefore, broader embodiments of the present invention are not limited by the above-described embodiments, and various changes can be made.

Industrial Applicability

As described above, the rectifying element according to the present invention is favorably used for a rectenna element.

Reference Signs List

1 First electrode
2 Second electrode
3 Semiconductor layer
4 Interface
5 Interface
10 Rectifying element
EB1, EB2, and EB3 Energy band structure

**Claims**

1. A rectifying element comprising:

   a first electrode having a first work function;
   a second electrode having a second work function larger than the first work function; and
   a semiconductor layer having a third work function that is a value between the first work function and the second work function, and joined to the first electrode and the second electrode.

2. The rectifying element according to claim 1, wherein the semiconductor layer is set to have a thickness with which the rectifying element becomes fully depleted in a state where a bias voltage is not applied between the first electrode and the second electrode.

3. The rectifying element according to claim 1 or 2, wherein a carrier of the semiconductor layer is a hole.

4. The rectifying element according to any one of claims 1 to 3, wherein the semiconductor layer is made of a metal oxide.

5. The rectifying element according to any one of claims 1 to 4, wherein the metal oxide is an NiOx (x = 1 to 1.5).

6. The rectifying element according to any one of claims 1 to 4, wherein the metal oxide is an NiOx (x = 1 to 1.5), the first electrode is made of Al, and the second electrode is made of Ni.

7. The rectifying element according to claim 6, wherein a hole concentration in the NiOx is in a $10^{-2}$ cm$^{-3}$ range to a $10^{17}$ cm$^{-3}$ range.

8. The rectifying element according to any one of claims 1 to 4, wherein the metal oxide is an NiOx (x = 1 to 1.5), the first electrode is made of Ni, the second electrode is made of Pt.

9. The rectifying element according to claim 8, wherein a hole concentration in the NiOx is in a $10^{17}$ cm$^{-3}$ range or more.

10. The rectifying element according to any one of claims 4 to 9, wherein the metal oxide is generated in a manner that a metal serving as a raw material of the metal oxide is irradiated with an ultraviolet ray and oxidized.

# FIG.1

# FIG.2A

# FIG.2B

# FIG.3

ELECTRONEGATIVITY (Pauling)

## FIG.4

## FIG.5

## INTERNATIONAL SEARCH REPORT

| International application No. |
|---|
| PCT/JP2013/067564 |

**A. CLASSIFICATION OF SUBJECT MATTER**
*H01L29/861(2006.01)i, H01L29/868(2006.01)i*

According to International Patent Classification (IPC) or to both national classification and IPC

**B. FIELDS SEARCHED**

Minimum documentation searched (classification system followed by classification symbols)
H01L29/861, H01L29/868

Documentation searched other than minimum documentation to the extent that such documents are included in the fields searched
| Jitsuyo Shinan Koho | 1922–1996 | Jitsuyo Shinan Toroku Koho | 1996–2013 |
| Kokai Jitsuyo Shinan Koho | 1971–2013 | Toroku Jitsuyo Shinan Koho | 1994–2013 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | P. Periasamy, J. D. Bergeson, P. A. Parilla, D. S. Ginley, R. P. O'Hayre, "Metal-insulator-metal point-contact diodes as a rectifier for rectenna" 35th Photovoltaic Specialists Conference (PVSC), IEEE, 2010,Figure 2-5, p. 002943 – 002945 | 1–10 |
| A | JP 2010-239233 A (Toyota Central Research and Development Laboratories, Inc.), 21 October 2010 (21.10.2010), entire text; all drawings & US 2010/0244656 A1 | 1–10 |

☐ Further documents are listed in the continuation of Box C.  ☐ See patent family annex.

| | |
|---|---|
| *  Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| 20 September, 2013 (20.09.13) | 01 October, 2013 (01.10.13) |

| Name and mailing address of the ISA/ | Authorized officer |
|---|---|
| Japanese Patent Office | |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008516455 W

**Non-patent literature cited in the description**

- **B. BERLAND.** Photovoltaic Technologies Beyond the Horizon: Optical Rectenna Solar Cell Final Report 1 August 2001-30 September 2002. *National Renewable Energy Laboratory,* February 2003
- **I. HOTOVY et al.** Characterization of NiO thin films deposited by reactive sputtering. *Vacuum,* 1998, vol. 50 (1-2), 41-44
- **R. SRNANEK et al.** A Raman study of NiOx films for gas sensors applications. *The Third International Euro Conference on Advanced Semiconductor Devices and Microsystems,* 2000, 303-306